Europäisches Patentamt

European Patent Office

Office européen des brevets

(19)

(11) Veröffentlichungsnummer: **0 134 540**
**B1**

(12) **EUROPÄISCHE PATENTSCHRIFT**

(45) Veröffentlichungstag der Patentschrift:
22.06.88

(51) Int. Cl.⁴: **H 05 K 9/00**

(21) Anmeldenummer: **84109197.8**

(22) Anmeldetag: **02.08.84**

(54) **Hochfrequenzdichte Abschirmung von Flächenteilen.**

(30) Priorität: **05.08.83 DE 3328395**

(43) Veröffentlichungstag der Anmeldung:
**20.03.85 Patentblatt 85/12**

(45) Bekanntmachung des Hinweises auf die Patenterteilung:
**22.06.88 Patentblatt 88/25**

(84) Benannte Vertragsstaaten:
**AT BE CH DE FR GB IT LI NL SE**

(56) Entgegenhaltungen:
**EP - A - 0 098 212**
**DE - B - 1 020 385**
**DE - B - 1 190 521**
**FR - A - 2 200 728**

**Die Akte enthält technische Angaben, die nach dem Eingang der Anmeldung eingereicht wurden und die nicht in dieser Patentschrift enthalten sind.**

(73) Patentinhaber: **Siemens Aktiengesellschaft Berlin und München, Wittelsbacherplatz 2, D-8000 München 2 (DE)**

(72) Erfinder: **Schmalzl, Dieter, Reichenaustrasse 33, D-8000 München 60 (DE)**

## Beschreibung

Die Erfindung betrifft eine hochfrequenzdichte Abschirmung von Flächenteilen bei Gerüst- und Blechkonstruktionen für elektronische Geräte, insbesondere der Datentechnik, wobei an den Berührungsstellen zwischen Gerüst und Flächenteil mindestens eine Feder, die in der Mitte eine Wölbung aufweist, befestigbar ist.

Aus der französischen Patentschrift 2 200 728 ist ein gegen hochfrequente elektromagnetische Störstrahlung abgeschirmtes Gehäuse für elektrische Geräte bekannt, das durch mindestens eine Tür frei zugänglich ist, die an ihrer Auflagefläche an dem Gehäuse eine in eine Vielzahl von Segmenten unterteilte elektrisch leitfähige Kontaktfederanordnung trägt, um an der ganzen Auflagefläche einen niedrigen Übergangswiderstand zwischen der Tür und dem Gehäuse zu gewährleisten. Dabei weist der Türrahmen auf der Innenseite einen Längsschlitz und parallel dazu verlaufend, einen U-förmig gebogenen Winkel mit der Öffnung in Richtung auf den Längsschlitz auf, wobei eine abgeknickte Kontaktfeder, deren seitliche Enden in den Längsschlitzen bzw. den Winkel unter federnder Vorspannung formschlüssig eingespannt sind, den Kontakt zwischen dem Türrahmen und dem Gehäuse herstellt. Dadurch wird eine Abschirmung gegen hochfrequente elektromagnetische Störstrahlung erreicht.

Aufgabe der Erfindung ist es, ein leicht austauschbares Kontaktteil für die hochfrequenzsichere Schirmung von Abdeckungen elektronischer Geräte zu schaffen.

Zur Lösung dieser Aufgabe wird die HF-dichte Abschirmung gemäss der Erfindung derart ausgebildet, dass an den Berührungsflächen zwischen Gerüst und Flächenteil im Flächenteil mindestens eine als Kontaktteil dienende Feder befestigbar ist, die aus zwei in nach aussen stehenden Federlappen auslaufenden Höckern und einer zwischen den beiden Höckern liegenden Stütznase besteht, dass in dem Flächenteil pro Feder zwei Durchbrüche zum Einführen der Federlappen und ein Widerlager für die Stütznase vorgesehen sind und dass die Feder so in die Durchbrüche der Flächenteile eingestellt ist, dass bei entspannter Feder die beiden Höcker über das Flächenteil hinausragen und die Federlappen gegen die Flächenrückseite und die Stütznase an der Flächenvorderseite gegen das Widerlager drücken.

Das Widerlager kann aus zwei Stegen und einem dazwischenliegenden Durchbruch bestehen, in dem die in ihrer Richtung entgegengesetzt zu den Höckern der Feder ausgeformte Stütznase eintaucht.

Die beiden Stege können eine in die Flächenteilinnenseite hineinragende Prägung aufweisen, so dass die Feder im gespannten Zustand in dieser Prägung zu liegen kommt.

Das Widerlager kann aber auch aus einem Steg bestehen, auf dem eine zu den Höckern der Feder in gleicher Richtung ausgeformte Stütznase, den Steg dreiseitig umfassend, aufliegt.

Durch diese Massnahmen erhält man eine einzelne in einem Blechdurchbruch einschnappbare Metallfeder, die sich durch ihre Form in der Lochung durch Rasten verankert und fixiert, an der Blechoberfläche eine Überdehnungsauflage findet, die zugleich als Kontaktstelle wirkt, und weitgehend unempfindlich ist. Die Anlage, sowohl in der Fassade als auch am Gerüst, bildet einen festen Doppelkontakt. Die Feder ist leicht einbau- bzw. austauschbar und daher in Vorrichtungen zur Montagevereinfachung vorgesehen. Sie lässt einen grossen Toleranzausgleich zu, und da sie trotz eines grossen Federweges nach hinten wenig in die Fassaden eintaucht, ist sie auch für dünne Fassaden anwendbar.

Zur Befestigung der Feder wird lediglich nur ein Formloch benötigt, das bei allgemeinen Lochungen der Blechteile fast ohne zusätzlichen Aufwand gefertigt werden kann. Dieses Formloch kann bei der Herstellung umlaufend an der Fassade angebracht werden, so dass je nach Anforderung der eingebauten Elektronik die Bestückung mit mehr oder weniger Federn erfolgen kann.

Erhält das Formloch beim Stanzen eine Prägung wie oben angeführt, so kann die Schirmwirkung durch den geringen Abstand zwischen Fassade und Gerüst erhöht werden, da die Feder in die Prägung eintaucht.

Anhand der Ausführungsbeispiele nach den Fig. 1 bis 10 wird die Erfindung näher erläutert. Es zeigen:

Fig. 1 eine Feder mit flachen Höckern,
Fig. 2 eine Feder mit höheren Höckern,
Fig. 3 eine Formlochung mit Prägung in Flächenteil,
Fig. 4 ein in das Flächenteil eingesetzte Feder,
Fig. 5 eine weitere Ausführungsform einer Feder,
Fig. 6 einen Querschnitt der in ein Flächenteil eingesetzten Feder nach Fig. 5,
Fig. 7 ein Flächenteil mit einer Formlochung für die Feder nach Fig. 5,
Fig. 8 eine schematische Darstellung des ersten Schrittes zur automatischen Bestückung einer Feder nach Fig. 1,
Fig. 9 eine schematische Darstellung des zweiten Schrittes für eine Bestückung einer Feder nach Fig. 1,
Fig. 10 eine schematische Darstellung des dritten Schrittes für eine automatische Bestückung für eine Feder nach Fig. 1,
Fig. 11, 12, 13 weitere Ausführungsformen der Feder.

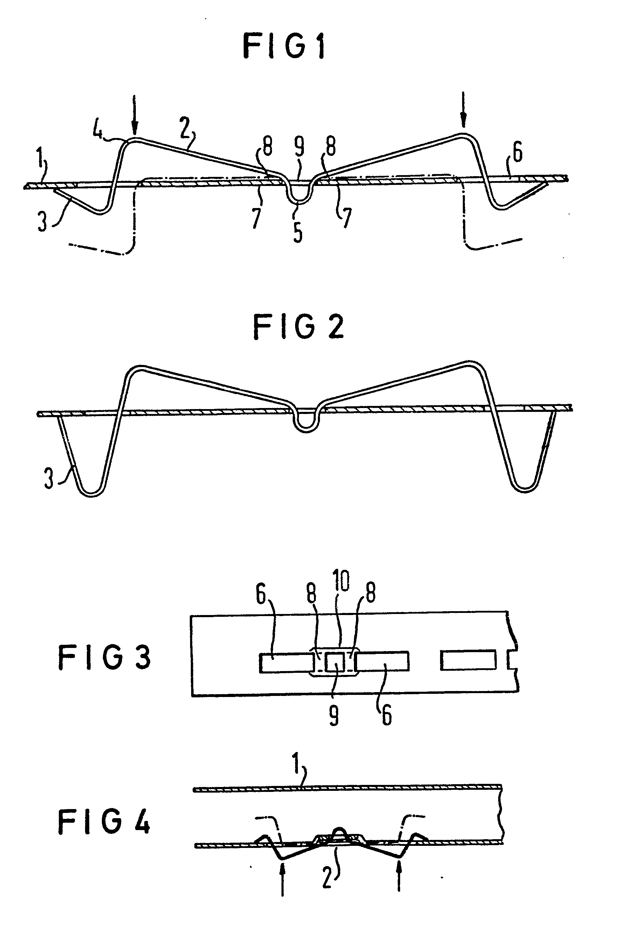

In Fig. 1 ist eine in einem Flächenteil 1, das im Querschnitt dargestellt ist, eingerastete Feder 2 gezeigt. Die Feder besteht aus zwei Höckern 4 und einer zwischen ihnen liegenden Stütznase 5. Die Höcker 4 sind unsymmetrisch ausgebildet, so dass die äussere Flanke steiler abfällt und in einem Federlappen 3, der etwa rechtwinklig gegenüber der Flanke abgebogen ist, ausläuft, während die andere Flanke zur Stütznase 5 hin langsam abfällt und die Stütznase 5 in einem Durchbruch 9 der zu beiden Seiten durch die Stege 8 begrenzt ist, eintaucht. Die Stütznase ist dabei in ihrer Richtung umgekehrt zu den beiden Höckern ausgebildet. Die Stütznase selbst ruht an der Verbindungsstelle mit den beiden flachen Flanken der Höcker auf den beidseitig angeordneten Stegen 8. Die steileren Flanken mit den auslaufenden Federlappen 3 werden durch weitere Durchbrüche 6 hindurchgeschoben und durch die Federwirkung werden die Lappen 3 in die Rückseite des Flächenteiles gedrückt, so dass die Feder sowohl in der Mitte an der Stütznase 5 als auch an den beiden Enden aufliegt und sich dadurch selbsttätig verrastet. Dabei befindet sich die Feder im Ruhezustand. Bei Aufbringen des Flächenteils 1 auf ein Gerüst werden die Höcker zusammengedrückt, so dass die Lappen 3 sich vom Flächenteil 1 abheben. Durch die Federwirkung entsteht dann eine gut kontaktierte Berührungsstelle zwischen dem Flächenteil 1 und dem zugehörigen, in der Zeichnung nicht dargestellten Gegenstücks.

Eine Feder, die in der gleichen Weise wirkt, die jedoch lediglich in der Ausbildung der steileren Flanke der Höcker und der Federlappen sich von der vorhergehend beschriebenen Feder unterscheidet, ist in Fig. 2 dargestellt. Dabei bilden die steile Flanke der Höcker 4 zusammen mit den auslaufenden Lappen eine V-förmige Gestalt. Damit ragen die Federlappen 3 weiter in die Innenseite des Flächenteils 1 hinein und durch die steileren Flanken von Höcker 4 und Federlappen 3 wird eine leichtere Einrastung der Feder erzielt.

Fig. 3 zeigt schematisch ein Flächenteil, in dem mehrere Formlochungen vorgesehen sind. Dabei weist jede Formlochung zwei seitliche Durchbrüche 6 sowie einen Mitteldurchbruch 9 auf, der durch die beiden Stege 8 von den äusseren Durchbrüchen 6 getrennt ist. Die Ausprägung 10 ist um die Stege herum vorgenommen.

Fig. 4 zeigt eine in ein Flächenteil 1 eingerastete Feder 2, wobei das Flächenteil im Umfeld des Durchbruchs 9 die Prägung 10 aufweist, wobei die Feder 2 in der entspannten Stellung (ausgezogen) und in der gespannten Stellung (strichpunktiert) dargestellt ist. In gespannter Stellung liegt die Feder in der Prägung und schliesst damit bündig mit der Fassadeninnenwand ab, wodurch eine günstigere HF-Schirmwirkung erzielbar ist.

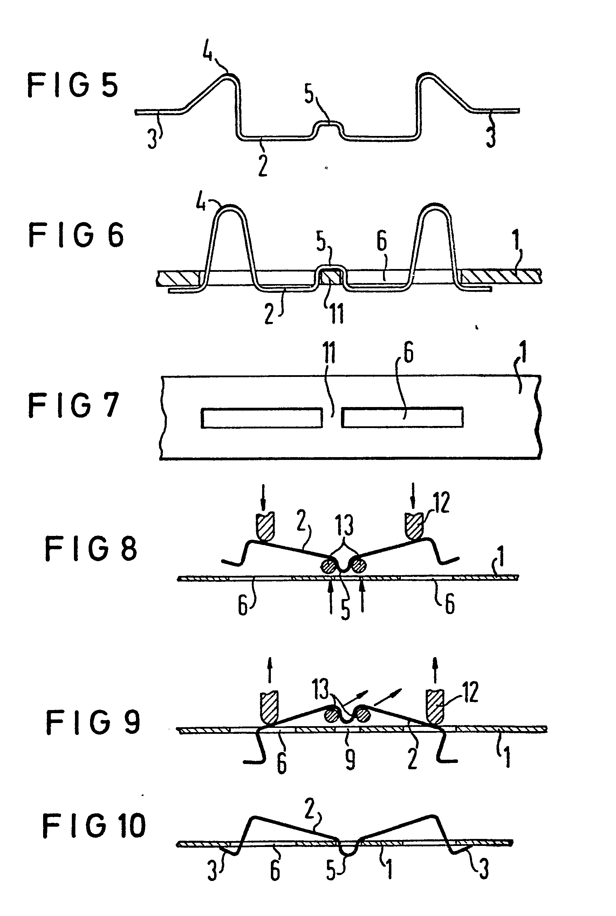

Eine andere Ausformung der Feder ist in Fig. 5 gezeigt. Bei dieser Ausführungsform ist die Stütznase für das Widerlager 5 in gleicher Richtung U-förmig gebogen ausgebildet wie die Höcker 4.

Wie in Fig. 6 dargestellt, umfasst die Stütznase 5 einen Steg 11 im Aufnahmeteil dreiseitig, die gleichzeitig als Kontaktstelle wirkt. Während die Federlappen 3 durch die Öffnungen 6 hindurchgestreckt sind und von hinten her an die Flächenteile 1 drücken, so dass dadurch die Feder selbsttätig gehalten wird. Beim Befestigen eines derartigen Flächenteils, das ein Flächenteil einer Datenverarbeitungsanlage sein kann, werden die Höcker nach unten gedrückt, so dass die Federlappen 3 von der Rückseite abstehen und durch den Steg 11 eine Spannung in der Feder 3 erzeugt wird, so dass die Feder ebenfalls sich gegen das die Flächenteile aufnehmende Gerüst drückt. Die Draufsicht einer Anordnung ohne Feder nach Fig. 6 stellt die Fig. 7 dar.

In den Fig. 8 bis 10 werden die einzelnen Schritte bei automatischer Bestückung einer Feder, wie sie in Fig. 1 gezeigt ist, dargestellt. Zwei Bolzen 13 sind rechts und links von der Stütznase 5 auf dem Flächenteil 1 aufgelegt. An den Höckern 2 greift das Werkzeug 12 an, das die Höcker nach unten in die Öffnungen 6 hineindrückt. Nach Wegnahme der Bolzen 13, wie in Fig. 9 dargestellt, ist die Feder mit ihren beiden Höckern 2 nach unten gedrückt und rastet mit der Stütznase 5 in die vorgesehene Öffnung 9 ein. Werden nun die Werkzeuge 12 nach oben gefahren, so entspannt sich die Feder und legt sich mit ihren beiden Lappen 3 an der Rückseite des Flächenteils 1 an, und damit ist der Bestückungsvorgang beendet.

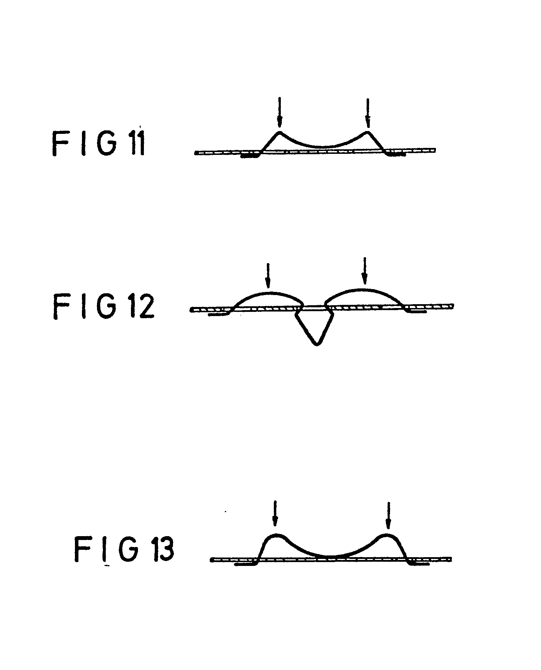

In Fig. 11 bis 13 sind weitere Ausführungsformen gezeigt, wobei die Feder nach Fig. 12 bezüglich Stütznase und Höcker eine Variante der Feder nach Fig. 1 darstellt während die Federn nach den Fig. 11 und 13 sich mit ihren Stütznasen auf einem Steg abstützen.

Alle Federn können auch aus Federdraht hergestellt werden.

**Patentansprüche**

1. Hochfrequenzdichte Abschirmung von Flächenteilen bei Gerüst- und Blechkonstruktionen für elektronische Geräte, insbesondere der Datentechnik, wobei an den Berührungsstellen zwischen Gerüst und Flächenteil mindestens eine Feder, die in der Mitte eine Wölbung aufweist, befestigbar ist, dadurch gekennzeichnet, dass an den Berührungsflächen zwischen Gerüst und Flächenteil im Flächenteil (1) mindestens eine als Kontaktteil dienende Feder (2) befestigbar ist, die aus zwei in nach aussen stehenden Federlappen (3) auslaufenden Höckern (4) und einer zwischen den beiden Höckern (4) liegenden Stütznase (5) besteht, dass in dem Flächenteil (1) pro Feder (2) zwei Durchbrüche (6) zum Einführen der Federlappen (3) und ein Widerlager (7) für die Stütznase (5) vorgesehen sind und dass die Feder (2) so in die Durchbrüche (6) der Flächenteile (1) eingestellt ist, dass bei entspannter Feder (2) die beiden Höcker (4) über das Flächenteil (1) hinausragen und die Federlappen (3) gegen die Flächenrückseite und die Stütznase (5) an der Flächenvorderseite gegen das Widerlager (7) drücken.

2. Hochfrequenzdichte Abschirmung nach Anspruch 1, dadurch gekennzeichnet, dass das Widerlager (7) aus zwei Stegen (8) und einem dazwischenliegenden Durchbruch (9) besteht, in dem die in ihrer Richtung entgegengesetzt zu den Höckern (4) der Feder (2) ausgeformte Stütznase (5) eintaucht.

3. Hochfrequenzdichte Abschirmung nach Anspruch 2, dadurch gekennzeichnet, dass die beiden Stege (8) eine in die Flächenteilinnenseite hineinragende Prägung (10) aufweisen.

4. Hochfrequenzdichte Abschirmung nach Anspruch 1, dadurch gekennzeichnet, dass das Widerlager aus einem Stück (10) besteht, auf dem eine zu den Höckern (4) der Feder (2) in gleicher Richtung ausgeformte Stütznase (5), den Steg (11) dreiseitig umfassend, aufliegt.

## Claims

1. High-frequency shield of surface parts on frame and sheet-metal structures for electronic equipment, especially in data systems engineering, at least one spring, having an arch in the centre, being fastenable at the points of contact between the frame and surface part, characterized in that at least one spring (2) serving as a contact part can be fastened in the surface part (1) at the contact sufaces between the frame and surface part and comprises two humps (4) ending in outward-projecting spring lugs (3) and a supporting nose (5) located between the two humps (4), in that two perforations (6) for inserting the spring lugs (3) and an abutment (7) for the supporting nose (5) are provided in the surface part (1) for each spring (2), and in that the spring (2) is fitted into the perforations (6) in the surface parts (1) in such a way that, when the spring (2) is relaxed, the two humps (4) project above the surface part (1) and press the spring lugs (3) against the rear side of the surface and the supporting nose (5) on the front side of the surface up against the abutment (7).

2. Hight-frequency shield according to claim 1, characterized in that the abutment (7) comprises two webs (8) and a perforation (9) which is located between these and in which penetrates the supporting nose (5) shaped in the opposite direction to the humps (4) of the spring (2).

3. High-frequency shield according to claim 2, characterized in that the two webs (8) have an embossing (10) intruding inwards into the surface part.

4. High-frequency shield according to claim 1, characterized in that the abutment comprises a piece (10), on which a supporting nose (5) shaped in the same direction as the humps (4) of the spring (2) rests so as to surround the web (11) on three sides.

## Revendications

1. Blindage contre des hautes fréquences pour des surfaces planes de constructions en treillis et en tôles pour des appareils électroniques, en particulier de la technique des données, du type dans lequel au moins un ressort qui comporte dans sa partie médiane un bombement, est susceptible d'être fixé aux emplacements de contact entre le treillis et l'élément de surface plane, caractérisé par le fait qu'au niveau des surfaces de contact entre le treillis et l'élément de surface plane est susceptible d'être fixé dans l'élément de surface plane (1), au moins un ressort (2) qui sert d'élément de contact et qui est constitué par deux pics (4) qui se terminent par des languettes élastiques (3) qui s'étendent vers l'extérieur et par un bec d'appui (5) qui se situe entre les deux pics (4), et que dans l'élément de surface plane (1), il est prévu, par ressort (2), deux ouvertures (6) servant à l'introduction des languettes élastiques (3), ainsi qu'un contre-appui (7) pour le bec d'appui (5), et que le ressort (2) est ajusté de telle manière dans les ouvertures (6) des éléments de surface plane (1) que lorsque le ressort (2) est détendu, les deux pics (4) débordent l'élément de surface plane (1), alors que les languettes (3) exercent une pression sur la face postérieure de l'élément de surface plane et que le bec d'appui (5) exerce une pression sur le contre-appui, au niveau du côté antérieur de l'élément de surface plane.

2. Blindage contre des hautes fréquences selon la revendication 1, caractérisé par le fait que le contre-appui (7) est constitué par deux barrettes (8) et par une ouverture (9) située entre ces dernières et dans laquelle plonge le bec d'appui (5) qui est conformé dans des directions opposées par rapport aux pics (4) du ressort (2).

3. Blindage contre des hautes fréquences selon la revendication 2, caractérisé par le fait que les deux barrettes (8) comportent une empreinte (10) qui pénètre dans la face intérieure de l'élément de surface plane.

4. Blindage contre des hautes fréquences selon la revendication 1, caractérisé par le fait que le contre-appui est fait d'une seule et même pièce (10) sur laquelle repose, en entourant la barrette (11) sur trois côtés, un bec d'appui (5) conformé dans la même direction que les pics (4) du ressort (2).

0 134 540

# FIG 1

# FIG 2

# FIG 3

# FIG 4

5

FIG 5

FIG 6

FIG 7

FIG 8

FIG 9

FIG 10

FIG 11

FIG 12

FIG 13